# EUROPÄISCHE PATENTANMELDUNG

(11) **EP 4 682 550 A1**
(43) Veröffentlichungstag der Anmeldung: **21.01.2026**
(21) Anmeldenummer: 25188057.1
(22) Anmeldetag: 08.07.2025
(51) Int. Cl.: G01R 23/17, G01R 29/08

(54) **SENSORKOPF FÜR EINEN FREQUENZANALYSATOR**

(30) Priorität: 18.07.2024 DE 102024002325
(71) Anmelder: Diehl Defence GmbH & Co. KG, 88662 Überlingen (DE)
(72) Erfinder: Münzhuber, Franz, 78315 Radolfzell am Bodensee (DE); Tholl, Hans Dieter, 88682 Salem (DE)
(74) Vertreter: Diehl Patentabteilung

(57) **Zusammenfassung**

Die Erfindung betrifft einen Sensorkopf (4a-d) für einen Frequenzanalysator (2a-d) enthaltend einen Kristallfehlstellenresonator (20a-d), einen optischen Pumpstrahler (14) zum Anregen des Kristallfehlstellenresonators (20a-d), eine Magnetfeldeinheit (30) zur Erzeugung eines Magnetfelds mit einem Magnetfeldgradienten entlang des Kristallfehlstellenresonators (20a-d), einen HF-Wellenleiter (22) und einen Strahlungsdetektor (10) zum Detektieren von Lumineszenzstrahlung (42) aus dem Kristallfehlstellenresonator (20a-d).

Um eine einfache Herstellbarkeit des Frequenzanalysators (2a-d) zu erreichen, wird vorgeschlagen, dass der Kristallfehlstellenresonator (20a-d) eine polykristalline Struktur aufweist.

## Beschreibung

Die Erfindung betrifft einen Sensorkopf für einen Frequenzanalysator enthaltend einen Kristallfehlstellenresonator, einen optischen Pumpstrahler zum Anregen des Kristallfehlstellenresonators, eine Magnetfeldeinheit zur Erzeugung eines Magnetfelds mit einem Magnetfeldgradienten entlang des Kristallfehlstellenresonators, einen HF-Wellenleiter und einen Strahlungsdetektor zum Detektieren von Lumineszenzstrahlung aus dem Kristallfehlstellenresonator.

Frequenzanalysatoren sind wichtiger Bestandteil der Überwachung, zum Beispiel eines Luftraums oder von Funkverkehr. Die Erfassung und Auswertung elektromagnetischer Signale im Frequenzbereich von wenigen kHz bis in den hohen Gigahertzbereich sind wichtige Aufgaben zur Erfassung von Aktivitäten im Luftraum oder in einem Funkverkehr. Ein erster Schritt zur Erfassung der konkreten Signale bzw. deren Auswertung ist die Untersuchung, welche Frequenzen zur Übertragung von Information genutzt werden. Hierfür muss ein Messsystem über den kompletten möglichen Frequenzbereich sensitiv sein und in Echtzeit die konkrete Frequenz ermitteln können, mit der ein Signal übertragen wird.

Heute eingesetzte Systeme funktionieren dabei nach dem Prinzip, dass eine Antenne alle vorhandenen Frequenzsignale einsammelt. Nach einiger Datenvorbereitung wird die Information über einen schnellen Analog-Digital-Wandler digitalisiert. Die digitale Wellenform wird dann fouriertransformiert, sodass sich daraus die Amplituden der einzelnen Frequenzbeiträge ergeben. Amplitudenpeaks deuten auf Frequenzen hin, die zum Senden verwendet werden. Diese Systeme haben trotz ihrer bewiesenen Einsatzfähigkeit den Nachteil, dass sie einen hohen Ressourcenbedarf haben. Die Komponenten sind schwer und teuer und der Bedarf an Rechnerleistung für das Durchführen einer schnellen Fourieranalyse der zeitlichen Signalform ist sehr hoch.

Ein vielversprechender weiterer Ansatz sind Frequenzanalysatoren auf der Basis von NV-Zentren (Stickstoff Vacancy) in Diamant. Hier werden Fehlstellen in Diamant optisch räumlich aufgelöst ausgelesen und die quantenoptischen Eigenschaften, wie zum Beispiel die spinabhängige Lumineszenz der NV-Zentren, werden ausgenutzt. Ein Magnetfeld, das entlang des Diamanten eine sich verändernde Magnetfeldstärke aufweist, sorgt dafür, dass an unterschiedlichen Stellen im Diamant die Photolumineszenz bei jeweils einer anderen Frequenz der eingestrahlten Strahlung abstrahlt. Dadurch steckt im Bild der Photolumineszenzintensität die Information darüber, welche Frequenzen auf den Diamanten einstrahlen.

Ein Sensorkopf eines Frequenzanalysators, der mit einem NV-Diamanten in einem Magnetfeld arbeitet, das entlang des Diamanten eine sich verändernde Magnetfeldstärke aufweist, ist in der EP3213093B1 beschrieben.

Es ist eine Aufgabe der vorliegenden Erfindung, einen einfacher herstellbaren Sensorkopf für einen Frequenzanalysator anzugeben.

Diese Aufgabe wird durch einen Sensorkopf der eingangs genannten Art gelöst, bei dem der Kristallfehlstellenresonator erfindungsgemäß eine polykristalline Struktur aufweist.

Die Erfindung geht von der Überlegung aus, dass die Aufspaltung der Energieniveaus durch das Magnetfeld nur dann in einem eindeutigen Zusammenhang zwischen Ort im Kristall und Frequenz der zu analysierenden Strahlung und damit der Stärke der Aufspaltung gegeben ist, wenn das Magnetfeld präzise in die Richtung einer Kristallachse des Diamanten ausgerichtet ist. Hierfür muss der Kristall ein Einkristall sein, damit seine Kristallachsen über den gesamten Lumineszenzbereich exakt gleich ausgerichtet sind. Entsprechend werden in Sensorköpfen, wie beispielsweise in der EP3213093B1 beschrieben, Einkristalle verwendet. Bei der Herstellung des Sensorkopfs ist also darauf zu achten, dass der Einkristall exakt justiert zum Magnetfeld liegt.

Dieser Nachteil kann mit einem polykristallinen Fehlstellenkristall umgangen werden. Denn in polykristallinem Material liegen immer Kristallbereiche vor, die zur Richtung des Magnetfelds korrekt ausgerichtet sind. Um nur oder vorwiegend die Lumineszenz von diesen Bereichen zu erfassen, kann die Polarisation der Strahlung des optischen Pumpens oder die Einstrahlung der zu analysierenden Strahlung so gewählt sein, dass sie diese Bereiche, also deren Kristallachsenausrichtung, bevorzugt. Oder die Lumineszenz wird in ihrer Ausrichtung gefiltert, beispielsweise durch einen Polarisationsfilter, sodass nur oder überwiegend Lumineszenz von den korrekt zum Magnetfeld ausgerichteten Bereichen des Polykristalls detektiert wird. Es ist damit keine Ausrichtung eines Einkristalls mehr notwendig, was die Herstellung vereinfacht. Zudem ist die Herstellung eines Polykristalls erheblich einfacher als die Herstellung eines Einkristalls der gleichen Größe. Weiter können Polykristalle in weitgehend beliebiger Geometrie und Größe hergestellt werden, sodass sie leichter an die Geometrie des Strahlungsdetektors angepasst werden können. Auch hierdurch wird die Herstellung erleichtert. Nachteilig am Polykristall ist die geringere Lumineszenzintensität in der gewünschten Frequenz bzw. Energie pro Kristallvolumen. Doch durch das leichtere Herstellen wesentlich größerer Polykristalle als Einkristalle kann dieser Nachteil ausgeglichen werden.

Die polykristalline Struktur ist vorteilhafterweise sehr fein, um eine gleichmäßige Richtungsverteilung der Kristallfehlstellen im Raum zu erreichen, auch wenn der Kristallfehlstellenresonator klein ist. Die Richtungsverteilung der Kristallfehlstellen im Kristallfehlstellenresonator ist zweckmäßigerweise isotrop im Raum verteilt. Die polykristalline Struktur wird zweckmäßigerweise durch einkristalline Korngrößen von 100 nm bis 10 µm gebildet. Bei einer mittleren Korngröße von unter 1 µm wird die polykristalline Struktur durch Nanokristalle gebildet. Die Korngröße kann sich auf einkristalline Bereiche innerhalb jeweils eines Kristalls beziehen oder auf die Korngröße der Kristalle. Der Kristallfehlstellenresonator kann auf einem Substrat aufgebracht sein, z.B. ein Diamantsubstrat oder ein Substrat aus einem anderen Material, wie Glas, Spinell oder Saphir.

Der Sensorkopf ist dazu vorgesehen, in einem Frequenzanalysator verwendet zu werden. Der Frequenzanalysator kann ein Analysator zur Ermittlung der Frequenz einfallender Strahlung sein, die insbesondere zu Kommunikationszwecken verwendet wird. Diese Strahlung wird im Folgenden als Hochfrequenzstrahlung (HF-Strahlung) bezeichnet und umfasst einen Frequenzbereich von 100 kHz bis 100 GHz, also den üblichen Mittelwellenbereich (militärischer Flugfunk), den UKW-Bereich (Flugfunk) bis zum Zentimeterwellenbereich (Radar, Richtfunk, Satellitenfunk). Die Erfindung ist auch gerichtet auf einen Frequenzanalysator mit einem solchen Sensorkopf. Zusätzlich zum Sensorkopf kann der Frequenzanalysator eine Ausleseelektronik für den Strahlungsdetektor enthalten und eine Auswerteelektronik zum Auswerten des Signals des Strahlungsdetektors, wobei beide Elektroniken mit Software zum Auslesen bzw. Auswerten ergänzt werden können.

Bei dem Kristallfehlstellenresonator kann es sich um ein Ensemble von Kristallfehlstellen in einem Wirtskristall handeln. Der Kristallfehlstellenresonator kann ein Fehlstellenkristall sein, dessen Fehlstellen-Photolumineszenz auf Anregung durch die zu analysierende HF-Strahlung reagiert. Der Kristallfehlstellenresonator kann ein Diamantfehlstellenresonator sein, also ein Diamant mit atomaren Fehlstellen, die nach optischem Pumpen Lumineszenzstrahlung abgeben. Konkret kann es ein NV-Diamant sein (Nitrogen Vacancy), bei dem die Fehlstellen durch Stickstoff im Diamantkristallgitter gebildet werden. Die polykristalline Struktur kann durch eine Vielzahl kleiner Kristalle, z.B. Diamanten, erreicht werden, oder durch einen einzigen polykristallinen Kristall, dessen Polykristallinität durch die Herstellung des Kristalls erzeugt wird. Die Magnetfeldeinheit kann ein Permanentmagnet sein, dessen Entfernung zum Polykristall zweckmäßigerweise einstellbar variabel ist. Hierdurch kann das Magnetfeld in seiner Stärke am Kristall eingestellt werden. Besonders vorteilhaft ist ein Elektromagnet, da dessen Feldstärke sehr schnell variiert werden kann, um gewählte Frequenzbereiche der HF-Strahlung scannen zu können. Die Stärke des Magnetfelds nimmt über die Detektionslänge des Polykristalls zu oder ab, was als Magnetfeldgradient entlang des Kristallfehlstellenresonators bezeichnet werden kann. Die Funktion der Stärke des Magnetfelds über den Raum ist frei wählbar, muss jedoch bekannt sein.

Der HF-Wellenleiter dient zum Transport der empfangenen HF-Strahlung in den Kristallfehlstellenresonator. Der HF-Wellenleiter kann eine Einheit sein, die die beispielsweise durch eine Antenne aus der Umgebung empfangene Multifrequenzstrahlung in den Kristallfehlstellenresonator einstrahlt. Er kann eine Sendeantenne sein, die mit einer Empfangsantenne, die die zu analysierende Strahlung empfängt, verbunden ist. HF-Frequenzen können sich von 100 kHz bis 100 GHz erstrecken. Der Kristallfehlstellenresonator kann im Nahfeld des HF-Wellenleiters platziert werden. Der Strahlungsdetektor zum Detektieren der Lumineszenzstrahlung aus dem Kristallfehlstellenresonator ist ein räumlich auflösender Detektor, beispielsweise ein Zeilendetektor, der entlang des Kristallfehlstellenresonators und entlang des Gradienten des Magnetfelds angeordnet ist. Möglich ist auch ein Matrixdetektor, der auf eine zweidimensionale Kristallfläche gerichtet ist. Hierdurch besteht die Möglichkeit, komplexere zweidimensionale Lumineszenzmuster abzubilden und zu analysieren, um mehrere HF-Frequenzen beispielsweise durch Differenzbildung von Musterbereichen besser trennen zu können.

In einer vorteilhaften Ausführungsform der Erfindung enthält der Sensorkopf einen Polarisator zwischen dem Kristallfehlstellenresonator und dem Strahlungsdetektor. Der die Energieniveaus aufspaltende Zeeman-Effekt ist abhängig von der Ausrichtung der Kristallstruktur zum Magnetfeld. Bei einer polykristallinen Struktur liegen alle möglichen Ausrichtungen vor, sodass alle Aufspaltungen von Null bis zu einer Maximalaufspaltung vorliegen, die von der Stärke des Magnetfelds abhängt. Bei einem Magnetfeldgradienten entlang des Polykristalls wird bei einer einzigen einfallenden HF-Frequenz daher nicht nur ein scharf lokalisierter Bereich in seiner Lumineszenz beeinflusst sondern ein durch den Polykristall durchgehender Bereich. Die optische Frequenztrennung verschiedener HF-Frequenzen ist hierdurch gestört. Diese Störung kann durch polarisierte optische oder HF-Anregung umgangen oder zumindest verbessert werden, wobei die einfachste Methode die Polarisationsfilterung der Lumineszenzstrahlung ist, da hierdurch wieder ein eindeutiger örtlicher Peak in der Beeinflussung der Amplitude der Lumineszenz erreicht werden kann. Um die Maximalaufspaltung der Energieniveaus ausnutzen zu können, ist es vorteilhaft, wenn die Polarisationsrichtung des Polarisators, insbesondere eines Polarisationsfilters entlang des Magnetfelds im Kristallfehlstellenstrahler ausgerichtet ist.

Die Herstellung eines Polykristalls kann auf verschiedene Weisen erfolgen. Besonders vorteilhaft kann die polykristalline Struktur durch ein epitaktisches, insbesondere heteroepitaktisches Wachstum der Kristalle auf einem Substrat erzeugt werden. Hierdurch können gezielt verschiedene geometrische Formen von Kristallen in einfacher Weise hergestellt werden. Das Substrat ist beispielsweise Silizium. Die polykristalline Struktur kann in einem zusammenhängenden Polykristall, beispielsweise durch epitaktisches Wachstum, erzeugt werden, oder in einer Vielzahl von Kristallen, die in geeigneter Weise wie ein einziger Festkörper oder als zusammenhängende Schicht zusammengehalten werden.

Die Photolumineszenz aus dem Kristallfehlstellenresonator sollte möglichst verlustarm zum Strahlungsdetektor geleitet werden. Entsprechend ist eine nahe Anordnung von Kristallfehlstellenresonator und Strahlungsdetektor von Vorteil. Eine nahe Anordnung und ein besonders kompakter Aufbau des Sensorkopfs kann erreicht werden, wenn der Kristallfehlstellenresonator und ein aktiver Bereich des Strahlungsdetektors jeweils als Schicht ausgeführt sind und zumindest mittelbar über ihre Flachseiten miteinander verbunden sind. Die Verbindung kann mit Verbindungsöl oder einer anderen geeigneten Methode erfolgen, z.B. aus der Halbleitertechnik. Zweckmäßigerweise ist die gesamte aktive Detektorfläche mit dem schichtförmigen Kristallfehlstellenresonator bedeckt.

Die Verbindung von Kristallfehlstellenresonator und Strahlungsdetektor kann unmittelbar erfolgen, z.B. mit Verbindungsöl, oder mittelbar, wobei dann ein oder mehrere weitere Elemente zwischen Kristallfehlstellenresonator und Strahlungsdetektor angeordnet sind, insbesondere jeweils schichtförmig, sodass der Sensorkopf einen Schichtenaufbau hat. Besonders vorteilhaft ist es, wenn zwischen dem Kristallfehlstellenresonator und dem aktiven Bereich des Strahlungsdetektors ein schichtförmiger Polarisator angeordnet ist, beispielsweise als Polarisatorfolie. Alternativ oder zusätzlich kann ein schichtförmiger Spektralfilter zwischen dem Kristallfehlstellenresonator und dem aktiven Bereich des Strahlungsdetektors angeordnet sein. Durch einen Grünfilter kann störender Einfall von grüner Pumpstrahlung in den Strahlungsdetektor verringert werden. Alternativ zu dem Schichtenaufbau kann ein Grünfilter in eine Optik zwischen dem Kristallfehlstellenresonator und dem Strahlungsdetektor angeordnet werden.

Die zu analysierende HF-Strahlung sollte möglichst verlustarm in den Kristallfehlstellenresonator eingestrahlt werden. Hierzu ist es vorteilhaft, den HF-Wellenleiter möglichst dicht und möglichst flächig auf dem Kristallfehlstellenresonator zu platzieren. Das kann erreicht werden, wenn der HF-Wellenleiter als Schicht auf dem Kristallfehlstellenresonator aufgebracht ist. Das Aufbringen kann mit einem Sprühverfahren, einem Rakelverfahren oder einer Ultraschallmethode erfolgen. Der HF-Wellenleiter kann als Schicht gegenüber dem Strahlungsdetektor auf dem Kristallfehlstellenresonator aufgebracht sein, sodass der HF-Wellenleiter ein Teil des Schichtenaufbaus des Sensorkopfs ist.

Der HF-Wellenleiter kann eine Schicht aus Indium-Zinn-Oxid oder einem anderen schichtförmigen elektrisch leitfähigen Material sein oder dieses enthalten. Besonders vorteilhaft ist die Bildung zumindest eines Teils des HF-Wellenleiters aus Nanodrähten, insbesondere Silbernanodrähten. Die Nanodrähte bilden ein Geflecht aus elektrisch leitfähigem Material, durch das die HF-Strahlung gleichmäßig in den Kristallfehlstellenresonator eingestrahlt werden kann. Möglich ist auch eine Mischung aus verschiedenen elektrisch leitfähigen Materialien, wobei diese Mischung zweckmäßigerweise Nanodrähte, insbesondere Silbernanodrähte, enthält. Das elektrisch leitfähige Material, wie Silbernanodrähte, kann in einer Dispersion auf einem Untergrund aufgebracht sein. Der Untergrund kann der Kristallfehlstellenresonator sein, sodass beide Elemente unmittelbar miteinander verbunden sind.

Eine noch engere Annäherung von HF-Wellenleiter und den strahlenden Fehlstellen im Kristallfehlstellenresonator kann erreicht werden, wenn zumindest ein Teil des HF-Wellenleiters und das polykristalline Material des Kristallfehlstellenresonators in einer gemeinsamen Schicht miteinander vermischt vorliegen. Der HF-Wellenleiter, beispielsweise Silbernanodrähte, kann mit Kristallen des polykristallinen Kristallfehlstellenresonators vermischt werden, und beide Materialien werden zweckmäßigerweise mit einem weiteren Material aneinander gebunden. Beide Materialien können in einer Dispersion mit beiden Elementen als disperse Phase vermischt sein. Das Dispersionsmedium sollte ein Material sein, das für die HF-Strahlung, Pumpstrahlung und Lumineszenz transparent ist. Die Transparenz des Kristallfehlstellenresonators ist durch die Nanodrähte nicht in störender Weise verringert, da das Nanodrahtnetzwerk transparent für Wellenlängen bis ca. 2 µm ist. Dadurch kann der Kristallfehlstellenresonator von außen ausgelesen werden.

Vorteilhafterweise liegen zumindest ein Teil des HF-Wellenleiters und der Kristallfehlstellenresonator, bzw. dessen polykristallines Material, jeweils in einer homogenen Verteilung in einer gemeinsamen Schicht vor. Der HF-Wellenleiter kann mehrere Bereiche oder Teile aufweisen, die unterschiedliche Eigenschaften aufweisen. Beispielsweise ist ein Teil homogen mit polykristallinem Material vermischt und ein anderer Teil als eigene Schicht ausgeführt.

Die Herstellung des Sensorkopfs kann weiter vereinfacht werden, wenn zumindest ein Teil des HF-Wellenleiters und der Kristallfehlstellenresonator in einer gemeinsamen Dispersionsschicht zumindest mittelbar auf ein Substrat aufgebracht wurden. Das Substrat kann der Strahlungsdetektor sein, beispielsweise dessen aktiver Bereich, oder ein Polarisator oder ein anderer Strahlungsfilter.

Der optische Pumpstrahler kann eine Strahlungsquelle haben, beispielsweise einen grünen Laser, und zweckmäßigerweise einen Lichtleiter, der die Pumpstrahlung zum Kristallfehlstellenresonator führt. Eine besonders gleichmäßige Bestrahlung des Kristallfehlstellenresonators kann erreicht werden, wenn der optische Pumpstrahler als Schicht zumindest mittelbar auf dem Kristallfehlstellenresonator angeordnet ist. Hierbei ist es ausreichend, wenn ein Teil des optische Pumpstrahlers als Schicht zumindest mittelbar auf dem Kristallfehlstellenresonator angeordnet ist, beispielsweise ein Strahlungsverteiler, denn aus diesem Teil strahlt das Pumplicht in den Kristallfehlstellenresonator, sodass dieser Teil auch als optischer Pumpstrahler bezeichnet werden kann. Die Lage der Strahlungsquelle des optischen Pumpstrahlers ist hierbei weniger wichtig. Die Pumpstrahlerschicht ist zweckmäßigerweise so ausgeführt, dass aus ihr die Pumpstrahlung gleichmäßig in den Kristallfehlstellenresonator eingestrahlt wird. Es ist auch möglich, dass in ihr die Pumpstrahlung erzeugt wird. Zweckmäßigerweise wird jedoch entfernt erzeugte Pumpstrahlung in der Schicht gleichmäßig verteilt und hierdurch gleichmäßig in den Kristallfehlstellenresonator eingestrahlt. Hierdurch kann die Strahlungsquelle entfernt vom Sensorkopf angeordnet werden, sodass der Sensorkopf kompakt bleiben kann.

Der HF-Wellenleiter kann als Schicht zwischen dem optische Pumpstrahler und dem Kristallfehlstellenresonator angeordnet sein. Auch ist es möglich, dass der HF-Wellenleiter und der Kristallfehlstellenresonator bzw. dessen polykristallines Material eine gemeinsame Schicht bilden und der optische Pumpstrahler als Schicht darauf gebildet ist. Ist die Schichtdicke des Kristallfehlstellenresonators oder der gemeinsamen Schicht aus Kristallfehlstellenresonator und HF-Wellenleiter dick genug, kann der optische Pumpstrahler alternativ oder zusätzlich seitlich in diese Schicht einstrahlen, zweckmäßigerweise von mehreren Seiten, sodass vorteilhafterweise eine homogene Beleuchtung entsteht.

Bei geringer Stärke der Lumineszenz kann es vorteilhaft sein, die Lumineszenzstrahlung möglichst vollständig einzufangen. Da diese in alle Richtungen abstrahlt, kann das Detektorsignal vergrößert werden, wenn der Kristallfehlstellenresonator als Schicht ausgeführt ist und der Strahlungsdetektor zwei schichtförmige Detektoreinheiten enthält, wobei der Kristallfehlstellenresonator zwischen den beiden Detektoreinheiten angeordnet ist. Sowohl nach oben als auch nach unten austretende Lumineszenzstrahlung kann auswertbar aufgefangen werden.

Die Impedanz im Teil des HF-Wellenleiters, in welchen die HF-Strahlung eingespeist wird, passt nicht zwangsläufig zur Impedanz im Teil des HF-Wellenleiters, in dem die HF-Strahlung in das Ensemble von Kristallfehlstellen, insbesondere in das Ensemble von Fehlstellen durch Stickstoff im Diamantkristallgitter abgestrahlt wird. Hierdurch kann es bei der Einstrahlung der HF-Strahlung in den Kristallfehlstellenresonator zu unerwünschten Dämpfungs- und/oder Reflexionseffekten kommen. Um diesen entgegenzuwirken, ist eine Impedanzeinheit vorhanden, die einen elektrischen Leiter aufweist, der zweckmäßigerweise auf einem vorbestimmten elektrischen Potenzial gehalten wird, z.B. auf der elektrischen Erdung oder einem anderen Nullpotenzial. Hierdurch können Dämpfungen und/oder Reflexionen der HF-Wellen beeinflusst bzw. eingestellt werden. Die Geometrie des elektrischen Leiters sollte an die Geometrie des Kristallfehlstellenresonators angepasst werden, sodass zweckmäßigerweise dessen Impedanz so eingestellt ist, dass Dämpfungs- und/oder Reflexionseffekte zumindest teilweise unterdrückt werden. Beispielsweise ist der elektrische Leiter entlang des Kristallfehlstellenresonators ausgerichtet, insbesondere gegenüberliegend beidseitig des Kristallfehlstellenresonators. Zum Halten des Leiters auf einem vorbestimmten elektrischen Potenzial kann dieser mit einem elektrischen Anschluss versehen sein oder mit diesem verbunden sein, sodass der Leiter über den Anschluss mit einem vorbestimmten elektrischen Potenzial gekoppelt werden kann.

Der Kristallfehlstellenresonator muss im Betrieb einem Gradientenmagnetfeld ausgesetzt werden. Besonders vorteilhaft umfasst der Sensorkopf ein Halbach-Array als Magnetfeldeinheit. Dieser kann mit Permanentmagneten oder Elektromagneten bestückt sein. Hierdurch kann das Magnetfeld an der dem Kristallfehlstellenresonator zugewandten Seite besonders kräftig sein. Durch eine Bewegung der Magnetfeldeinheit oder Steuerung der Ströme durch die Elektromagneten kann das Magnetfeld verändert werden, sodass in schneller Folge ein großer Frequenzbereich der HF-Strahlung grob und ein kleinerer Frequenzbereich der HF-Strahlung genauer untersucht werden kann. Die Bewegung kann eine Translation des Magneten vom Kristallfehlstellenresonator weg oder zu ihm hin sein oder eine Rotation des Magneten.

Die Erfindung ist außerdem gerichtet auf ein Verfahren zum Analysieren eines Frequenzspektrums von Strahlung, bei dem die Strahlung in eine HF-Antenne eingekoppelt wird, die mit einem HF-Wellenleiter eines Sensorkopf eines Frequenzanalysators verbunden ist, die Strahlung mit einem durch optisches Pumpen angeregten und in einem Gradientenmagnetfeld liegenden Kristallfehlstellenresonator interagiert und Lumineszenzstrahlung aus dem Kristallfehlstellenresonator einen Strahlungsdetektor erreicht. Um eine einfache Herstellung des Sensorkopfs zu erreichen, wird die Lumineszenzstrahlung erfindungsgemäß durch eine polykristalline Struktur des Kristallfehlstellenresonators erzeugt. Vorteilhafterweise wird die Lumineszenzstrahlung mit einem Polarisationsfilter gefiltert, bevor sie den Strahlungsdetektor erreicht.

Mit dem Verfahren kann eine große Bandbreite von HF-Strahlung frequenzabhängig unmittelbar optisch sichtbar gemacht werden. Die Frequenzauflösung kann jedoch nicht ausreichen, um die einstrahlenden HF-Frequenzen genau genug erfassen zu können. Dieser Nachteil kann mit einem veränderlichen Magnetfeld umgangen werden, beispielsweise durch das Bewegen oder Steuern eines Halbach-Arrays. Es kann ein HF-Signal in einem großen Bandbereich gesucht werden und dann das Band mithilfe des Magnetfelds verengt werden und das HF-Signal mit höherer Frequenzgenauigkeit gesucht werden.

Die bisher gegebene Beschreibung vorteilhafter Ausgestaltungen der Erfindung enthält zahlreiche Merkmale, die teilweise in einigen abhängigen Ansprüchen zu mehreren zusammengefasst wiedergegeben sind. Die Merkmale können jedoch zweckmäßigerweise auch einzeln betrachtet und zu sinnvollen weiteren Kombinationen zusammengefasst werden, insbesondere bei Rückbezügen von Ansprüchen, sodass ein einzelnes Merkmal eines abhängigen Anspruchs mit einem einzelnen, mehreren oder allen Merkmalen eines anderen abhängigen Anspruchs kombinierbar ist. Außerdem sind diese Merkmale mit dem erfindungsgemäßen Verfahren als auch mit der erfindungsgemäßen Vorrichtung gemäß den unabhängigen Ansprüchen kombinierbar. So sind Verfahrensmerkmale auch als Eigenschaften der entsprechenden Vorrichtungseinheit gegenständlich formuliert zu sehen und funktionale Vorrichtungsmerkmale auch als entsprechende Verfahrensmerkmale.

Die oben beschriebenen Eigenschaften, Merkmale und Vorteile dieser Erfindung sowie die Art und Weise, wie diese erreicht werden, werden klarer und deutlicher verständlich in Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und/oder mit einem beliebigen der Ansprüche kombiniert werden.

Es zeigen:
- FIG 1: einen Frequenzanalysator mit einem Sensorkopf, der einen polykristallinen NV-Diamanten zwischen einem HF-Wellenleiter und einem Strahlungsdetektor enthält,
- FIG 2: Frequenzspektren von Lumineszenzstrahlung aus einem monokristallinen NV-Diamanten und einem polykristallinen NV-Diamanten,
- FIG 3: einen Frequenzanalysator, bei dem der NV-Diamant zwischen einem Lichtverteiler eines optischen Pumpstrahlers und dem Strahlungsdetektor liegt,
- FIG 4: einen Frequenzanalysator, bei dem der NV-Diamant zusammen mit einem HF-Wellenleiter eine gemeinsame Schicht bildet, und
- FIG 5: einen Frequenzanalysator mit zwei Strahlungsdetektorelementen beidseitig des NV-Diamanten.

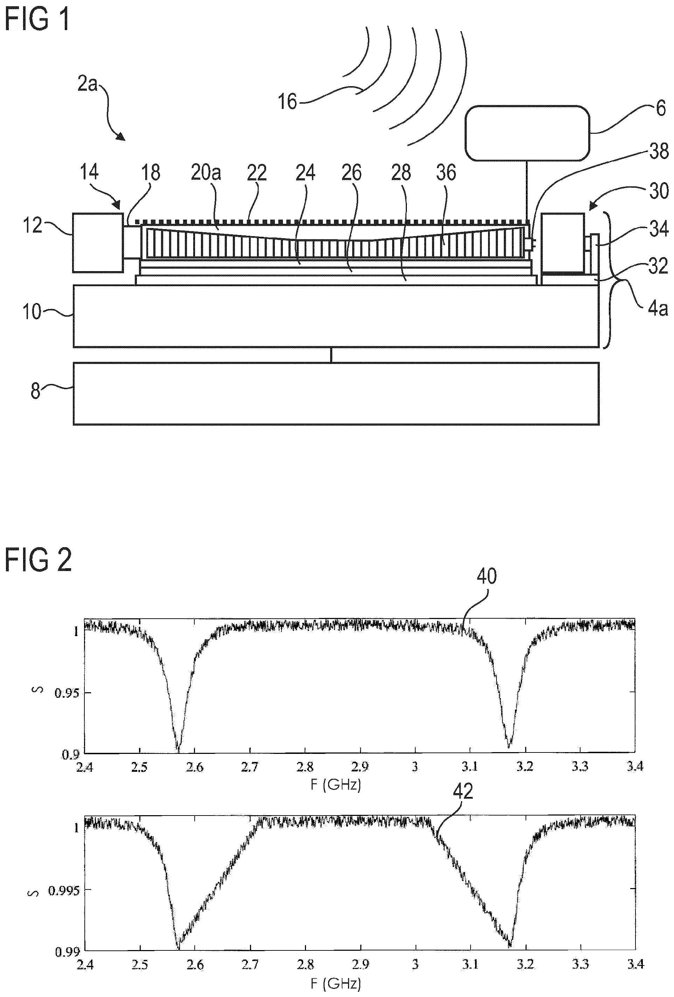

FIG 1 zeigt einen Frequenzanalysator 2a mit einem Sensorkopf 4a, einer HF-Empfangsantenne 6 und einer Auswerteeinheit 8 für einen Strahlungsdetektor 10. Eine Lichtquelle 12 eines optischen Pumpstrahlers 14 ist über einen Lichtleiter 18 mit einem Kristallfehlstellenresonator 20a verbunden. Der Frequenzanalysator 2a dient zum Erkennen von HF-Strahlung 16 und dessen Frequenzen, die beispielsweise von Kommunikation aus einem Luftraum stammt und auf die HF-Empfangsantenne 6 einstrahlt. Die HF-Empfangsantenne 6 und die Auswerteeinheit 8 können entfernt vom Sensorkopf 4a angeordnet und daher nicht Teil von ihm sein. Gleiches gilt auch für die Lichtquelle 12, die über den Lichtleiter 18 mit dem Sensorkopf 4a verbunden werden kann. Lichtquelle 12 und/oder Auswerteeinheit 8 können jedoch auch Teil des Sensorkopfs 4a sein, wenn sie beispielsweise kompakt angeordnet sind.

Der Sensorkopf 4a umfasst als zentrales Element den Kristallfehlstellenresonator 20a. Dieser ist ein polykristalliner NV-Diamant, also ein aus vielen Diamant-Einzelkristallen zusammengesetzter Polykristall, dessen Diamant-Kristallgitter mit Stickstoffatomen durchsetzt ist. Ein Stickstoffatom anstelle eines Kohlenstoffatoms erzeugt in seiner Nachbarschaft eine Kristallgitterfehlstelle (NV: Nitrogen Vacancy). Die vielen Diamant-Einzelkristalle können Einkristalle sein oder auch Gitterbrüche enthalten, sodass mehrere Gitterausrichtungen in einem Einzelkristall vorhanden sind. Die Einzelkristalle sind in ihrer Gitterausrichtung im Polykristall zumindest im Wesentlichen statistisch verteilt, sodass keine vorherrschende Gitterausrichtung vorhanden sein muss. Die Einzelkristalle sind durch das Herstellungsverfahren des Kristallfehlstellenresonators 20a in eine Form gebracht, beispielsweise eine Schicht mit einer Dicke von weniger als einem Millimeter. Das Herstellen kann eine Einbindung der Einzelkristalle in ein Trägermaterial sein, das in die gewünschte Form gebracht wird. Beispielsweise wird eine Dispersion hergestellt mit den Einzelkristallen als disperse Phase und einem Trägermaterial, das in die gewünschte Form gebracht und dann getrocknet oder anders gehärtet wird. Der Polykristall des Kristallfehlstellenresonators 20a ist durch sein Herstellungsverfahren in eine Form gebracht, die zwei zueinander parallele und ebene Flachseiten aufweist. Je nach Dicke kann die Form eine Schicht oder ein Quader sein.

Auf der einen Flachseite des Kristallfehlstellenresonators 20a ist ein HF-Wellenleiter 22 in Form eines metallischen Geflechts aufgebracht, der mit der HF-Empfangsantenne 6 elektrisch leitend verbunden ist, wie in FIG 1 dargestellt ist. Das Metallgeflecht kann ein regelmäßiges Metallgitter bilden oder ein unregelmäßiges Metallgeflecht. Das von der HF-Empfangsantenne 6 empfangene HF-Signal wird in den HF-Wellenleiter 22 geleitet, der das HF-Signal dann in den Kristallfehlstellenresonator 20a einstrahlt, zweckmäßigerweise entlang dessen gesamter Flachseite. Hierdurch wird eine gleichmäßige Verteilung des HF-Signals in den Kristallfehlstellenresonator 20a erreicht, verbunden mit einer hohen Lumineszenzreaktion des Kristallfehlstellenresonators 20a auf die HF-Strahlung 16. Auf der anderen Flachseite des Kristallfehlstellenresonators 20a ist der Strahlungsdetektor 10 angeordnet, wobei der Kristallfehlstellenresonator 20a über seine Flachseite mittelbar mit dem Strahlungsdetektor 10 verbunden ist. Die Mittelbarkeit kommt dadurch zustande, dass zwischen dem Kristallfehlstellenresonator 20a und dem Strahlungsdetektor 10 ein Polarisationsfilter 24 in Form einer Polarisationsfolie und ein Spektralfilter 26, ebenfalls in Form einer Folie, angeordnet sind. Der Spektralfilter 26 liegt unmittelbar auf einem aktiven Bereich 28 des Strahlungsdetektors 10 in Form einer sensitiven Schicht des Strahlungsdetektors 10 auf. Der Strahlungsdetektor 10 dient zum Detektieren von Lumineszenzstrahlung aus dem Kristallfehlstellenresonator 20a.

Seitlich des Kristallfehlstellenresonators 20a ist eine Magnetfeldeinheit 30 angeordnet zur Erzeugung eines Magnetfelds mit einem Magnetfeldgradienten entlang des Kristallfehlstellenresonators 20a. Die Magnetfeldeinheit 30 umfasst an seiner dem Kristallfehlstellenresonator 20a zugewandten Seite ein Halbach-Array, das ein Magnetfeld erzeugt. Die Magnetfeldeinheit 30 kann einen oder mehrere Permanentmagnete enthalten, die ein statisches Magnetfeld erzeugen. Durch die Ausrichtung des Kristallfehlstellenresonators 20a seiner Länge nach von der Magnetfeldeinheit 30 weg, ist das Magnetfeld im Bereich des Kristallfehlstellenresonators 20a mit einem Amplitudengradienten behaftet, sodass das Magnetfeld in seiner Stärke kontinuierlich über die Länge des Kristallfehlstellenresonators 20a abnimmt. Zur Variation des Magnetfelds kann der Permanentmagnet der Magnetfeldeinheit 30 mechanisch zum Kristallfehlstellenresonator 20a hin und von ihm wegbewegt werden, beispielsweise über einen Schlitten 32 und einen Antrieb 34, die in FIG 1 der Übersichtlichkeit halber nur verkleinert dargestellt sind. Eine einfachere Verstellung des Magnetfelds kann erreicht werden, wenn der Magnet der Magnetfeldeinheit 30 ein oder mehrere Elektromagneten aufweist, beispielsweise in Form eines Halbach-Arrays. Die Elektromagneten können ohne mechanische Bewegung angesteuert und das Magnetfeld wie gewünscht verändert werden.

FIG 1 zeigt die Lichtquelle 12 und die Magnetfeldeinheit 30 gegenüberliegend. Dies ist nur eine vereinfachte Darstellung der Übersichtlichkeit halber. Besser sind zwei Lichtquellen 12 vorhanden, die einander gegenüberstehen und von entgegengesetzten Seiten in den Kristallfehlstellenresonator 20a einstrahlen, oder, äquivalent dazu, zwei Lichtleiter 18 an einer gemeinsamen Lichtquelle 12, die an gegenüberliegenden Seiten in den Kristallfehlstellenresonator 20a einstrahlen. Die Magnetfeldeinheit 30 ist, entgegen der vereinfachten Darstellung aus FIG 1, zweckmäßigerweise quer versetzt zu dem oder den beiden Lichtquellen 12 bzw. Lichtleitern 18 angeordnet.

Entlang des Kristallfehlstellenresonators 20a ist eine Impedanzeinheit 36 angeordnet, die in Form eines metallischen Leiters ausgeführt ist. Dieser kann unmittelbar an einer Seite mit dem Kristallfehlstellenresonator 20a verbunden sein, wie in FIG 1 angedeutet ist, oder an zwei gegenüberliegenden Seiten. Vorteilhafterweise ist die Impedanzeinheit 36 an einer anderen Seite angeordnet, wie die Lichtquelle 12 bzw. ihr Lichtleiter 18. Beispielsweise sind zwei Lichtquellen 12 einander gegenüber angeordnet und zwei Leiter einer Impedanzeinheit 36 einander gegenüber und quer zu den Lichtquellen 12. Die Magnetfeldeinheit 30 kann dann an der Seite eines Leiters bzw. einer Impedanzeinheit 36 liegen und sein Magnetfeld durch die Impedanzeinheit 36 hindurch ausbreiten. Die Impedanzeinheit 36 weist einen Anschluss 38 auf, z.B. einen Stecker oder eine andere elektrische Schnittstelle, mit der die Impedanzeinheit 36 auf einem festgelegten, vorbekannten elektrischen Potenzial verbunden werden kann, sodass die Impedanzeinheit 36 auf diesem Potenzial liegt. Die Impedanzeinheit 36 beeinflusst die Impedanz des Kristallfehlstellenresonators 20a für die HF-Strahlung 16, sodass diese nicht oder nur vermindert durch Dämpfung und/oder Reflexionen gestört wird. Die Geometrie der Impedanzeinheit 36 ist in der Weise an die Geometrie des Kristallfehlstellenresonators 20a angepasst, dass Dämpfung und/oder Reflexionen vermindert werden. Es ist auch möglich, die Impedanzeinheit 36 nur oder auch an einer Flachseite des Kristallfehlstellenresonators 20a zu platzieren oder seitlich über Eck am Kristallfehlstellenresonator 20a anzuordnen.

Beim Betrieb des Frequenzanalysators 2a erzeugt die Lichtquelle 12 als optischer Pumpstrahler 14 Pumplicht zum Anregen des Kristallfehlstellenresonators 20a, bei einem NV-Diamanten in grüner Farbe von beispielsweise 632 nm. Die Lichtquelle 12 kann ein grüner Laser sein, deren Strahlung über den Lichtleiter 18 in den Kristallfehlstellenresonator 20a einstrahlt und hierdurch ein optisches Pumpen in den Fehlstellen des Kristallfehlstellenresonators 20a erzeugt. Hierdurch werden Elektronen in ein höheres Energieniveau angehoben und fallen, Lumineszenzstrahlung abgebend, wieder in das Grundniveau zurück. Bei einem NV-Diamanten ist die Lumineszenzstrahlung rot. Der Kristallfehlstellenresonator 20a erzeugt in seinem gesamten polykristallinen Bereich Lumineszenzstrahlung. Das Magnetfeld spaltet durch den Zeeman-Effekt das Grundniveau in zwei Niveaus auf. Die Aufspaltung ist in seinem Energieabstand zwischen den Niveaus über die Länge des Kristallfehlstellenresonators 20a verschieden, z.B. kontinuierlich abnehmend bei über die Länge kontinuierlich abnehmendem Magnetfeld. Über den HF-Wellenleiter 22 strahlt HF-Strahlung 16 in den Kristallfehlstellenresonator 20a ein. Dort, wo die Energie der HF-Strahlung 16 mit dem energetischen Abstand der aufgespalteten Energieniveaus zusammenfällt, wird die Lumineszenzstrahlung beeinflusst, sodass dort ein Dip im Lumineszenzspektrum erscheint. Da die Aufspaltungsenergie über die Länge des Kristallfehlstellenresonators 20a aufgrund der bekannten Magnetfeldstärke bekannt ist, gibt der Ort des Dips im Kristallfehlstellenresonator 20a die Frequenz der eingestrahlten HF-Strahlung 16 an. Dies ist in FIG 2 dargestellt.

FIG 2 zeigt in seinem oberen Diagramm die Dips der Lumineszenzstrahlung 40 von den beiden aufgespalteten Energieniveaus über die Frequenz F der Aufspaltung an. Die Aufspaltung, also der Abstand der Dips, ist abhängig von der Magnetfeldstärke. Aufgetragen ist die Signalstärke S des Lumineszenzsignals gegen die Energie als Frequenz F in GHz. Der Effekt der Detektierbarkeit der in FIG 2 gezeigten Aufspaltung tritt in der Weise nur dann auf, wenn das Magnetfeld parallel zur Fehlstellenausrichtung im Kristallgitter ist. In einem NV-Diamant-Einkristall kann dies bei entsprechender

Ausrichtung des Kristalls zum Magnetfeld erreicht werden. In einem Polykristall nimmt die Niveauaufspaltung jedoch bei gleichem Magnetfeld mit wachsendem Winkel der Fehlstellenausrichtung im Kristallgitter zum Magnetfeldgradienten ab, sodass der Dip über einen ganzen Bereich des Polykristalls erscheint und nicht in einer Frequenz auflösbar ist. Die beiden unteren Dips in FIG 2 würden entsprechend zu einem einzigen verschmelzen.

Allerdings ist die Lumineszenzstrahlung polarisiert in Richtung der der Fehlstellenausrichtung im Kristallgitter. Mit dem Polarisationsfilter 24 kann somit eine Auswahl des Lichts aus den statistisch verteilten Fehlstellenausrichtungen im Kristallgitter getroffen werden. Beispielsweise wird die Ausrichtung des Polarisationsfilters 24 parallel zum Magnetfeld gewählt, sodass i.W. nur die Lumineszenzstrahlung den Strahlungsdetektor 10 zum Detektieren der Lumineszenzstrahlung erreicht, die von denjenigen Fehlstellen kommt, die parallel zum Magnetfeld liegen. Diese polarisationsgefilterte Lumineszenzstrahlung 42 ist im unteren Diagramm von FIG 2 gezeigt. Es ist zu sehen, dass die beiden Dips nach außen hin ähnlich scharf sind wie im oberen Diagramm. Nach innen hin schmieren sie deutlicher aus, was daran liegt, dass der Polarisationsfilter nicht nur Strahlung von den in seine Polarisationsrichtung ausgerichteten Fehlstellen passieren lässt, sondern auch einen Anteil der nicht so ausgerichteten Fehlstellen, wobei dieser Anteil mit wachsendem Winkel zur Polarisationsrichtung abnimmt, also mit wachsendem Abstand zur Dipspitze. Weiterhin ist zu sehen, dass die Dips aus dem Polykristall, also des unteren Diagramms, um eine Größenordnung kleiner sind, als die Dips aus dem Einkristall (oberes Diagramm). Doch dieser Nachteil kann durch die einfache Herstellung großer Polykristalle und dadurch lichtintensivere Signale wettgemacht werden.

Zum Erkennen von HF-Frequenzen in einem Frequenzbereich kann der Magnetfeldgradient so eingestellt werden, dass die Aufspaltung den gesamten Frequenzbereich abdeckt. Bereiche, in denen Auffälligkeiten entdeckt werden, können dann genauer untersucht werden, indem der Magnetfeldgradient so gewählt wird, dass nur der gewünschte HF-Bereich untersucht wird. Das HF-Frequenzsignal kann hierdurch höher aufgelöst untersucht werden. Auf diese Weise kann innerhalb des gesamten Frequenzbereichs ein oder mehrere kleinere HF-Frequenzbereiche gezielt isoliert untersucht werden zum genaueren Bestimmen der einstrahlenden HF-Frequenz.

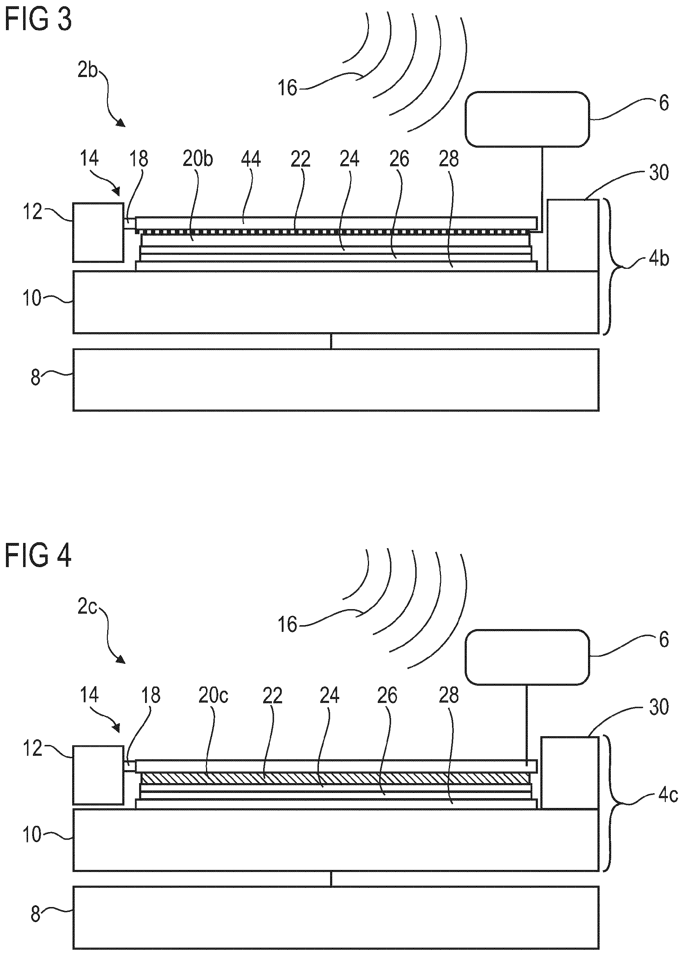

Eine alternative Anordnung in einem Sensorkopf 4b eines Frequenzanalysators 2b ist in FIG 3 dargestellt. Die nachfolgende Beschreibung beschränkt sich im Wesentlichen auf die Unterschiede zum Ausführungsbeispiel aus FIG 1, auf das bezüglich gleich bleibender Merkmale und Funktionen verwiesen wird. Um nicht bereits Beschriebenes mehrfach ausführen zu müssen, sind generell alle Merkmale eines vorangegangenen Ausführungsbeispiels im jeweils folgenden Ausführungsbeispiel übernommen, ohne dass sie erneut beschrieben sind, es sei denn, Merkmale sind als Unterschiede zu dem vorangegangenen Ausführungsbeispiel beschrieben. Außerdem sind im Wesentlichen gleich bleibende Bauteile mit den gleichen Bezugsziffern angegeben, wobei abweichende Bezugsbuchstaben auf Unterschiede hinweisen, die in der Beschreibung genauer charakterisiert sind.

FIG 3 zeigt einen Sensorkopf 4b, bei dem der Kristallfehlstellenresonators 20b als Schicht aus Einzelkristallen ausgeführt ist, die weniger als 1 mm dick ist. Die Schicht wurde durch eine Dispersion mit den Einzelkristallen hergestellt, die auf den Polarisationsfilter 24 aufgetragen wurde. Möglich ist auch ein Sprühverfahren, Rakeln oder ein Ultraschallauftragen. Die Schicht ist erheblich dünner als bei dem Ausführungsbeispiel aus FIG 1 und kann mit getrübter Transparenz behaftet sein, sodass ein Einstrahlen der Pumpstrahlung von der Seite mit größeren Verlusten behaftet ist. Daher strahlt die Lichtquelle 12 in einen Lichtverteiler 44, der die Pumpstrahlung gleichmäßig in eine Flachseite des Kristallfehlstellenresonators 20b einträgt. Der optische Pumpstrahler 14 ist insofern als Schicht auf dem Kristallfehlstellenresonator 20b angeordnet, wenngleich nur mit seinem Lichtverteiler 44. Es ist möglich, jedoch aufwändiger, auch die Lichtquelle 12 als Schicht auszubilden. Die Magnetfeldeinheit 30 ist als Halbach-Array mit Elektromagneten ausgeführt.

Zwischen dem Lichtverteiler 44 und dem Kristallfehlstellenresonator 20b ist der HF-Wellenleiter 22 angeordnet. Dieser kann ein Metallgeflecht sein. Wie auch beim Ausführungsbeispiel aus FIG 1 kann das Metallgeflecht durch Nanodrähte gebildet sein, insbesondere Silbernanodrähte. Diese können in einer Dispersion als Schicht auf ein Substrat aufgetragen sein, in diesem Fall auf den Kristallfehlstellenresonator 20b oder den Lichtverteiler 44. Die Nanodrähte liegen wie beim Ausführungsbeispiel aus FIG 1 ungeordnet in der Dispersion vor und bilden durch ihre gegenseitige Verbindung ein elektrisch leitfähiges Netz über dem Kristallfehlstellenresonator 20b, sodass dieser gleichmäßig mit der HF-Strahlung 16 bestrahlt wird. Die Nanodrähte bzw. die Dispersion kann mittels Sprühverfahren, Rakeln oder Ultraschallverfahren aufgetragen sein. Eine Impedanzeinheit ist in FIG 3 der Übersichtlichkeit halber nicht dargestellt, kann aber ausgeführt sein wie beim Ausführungsbeispiel aus FIG 1, jedoch mit einer an die geringere Schichtdicke angepassten Geometrie.

Bei dem Ausführungsbeispiel aus FIG 4 mit einem Frequenzanalysator 2c mit einem Sensorkopf 4c liegen der Kristallfehlstellenresonator 20c und der HF-Wellenleiter 22 als gemeinsame Schicht vor. Die Nanodrähte, z.B. Silbernanodrähte, sind mit den Einzelkristallen des Polykristalls in einer homogenen Verteilung in einer Schicht vermischt. Bei der Herstellung wurden sie als Dispersion zusammen vermischt und als eine Schicht aufgebracht, z.B. wie oben zum Kristallfehlstellenresonator 20b und dem HF-Wellenleiter 22 beschrieben. Hierdurch wird die HF-Strahlung 16 noch näher an die Fehlstellen des Polykristalls gebracht, sodass das Lumineszenzsignal verstärkt wird.

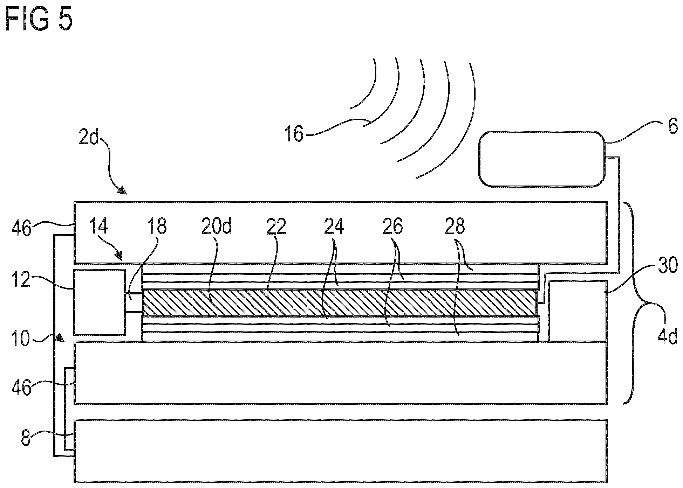

FIG 5 zeigt ein Ausführungsbeispiel mit einem Frequenzanalysator 2d mit einem Sensorkopf 4d mit dem eine besonders gute Lumineszenzausbeute erreicht werden kann. Wie bei dem Ausführungsbeispiel aus FIG 4 liegen der Kristallfehlstellenresonator 20d und der HF-Wellenleiter 22 als gemeinsame Schicht vor. Diese kann jedoch dicker sein als in FIG 4. Der Strahlungsdetektor 10 enthält zwei Detektoreinheiten 46, die beidseitig des Kristallfehlstellenresonators 20d angeordnet sind und die mit einer gemeinsamen Auswerteeinheit 8 verbunden sein können. Hierdurch wird im Wesentlichen die gesamte Lumineszenz aus dem Kristallfehlstellenresonator 20d dem Strahlungsdetektor 10 zugeführt. Ebenfalls beidseitig des Kristallfehlstellenresonators 20d liegen jeweils ein Polarisationsfilter 24 und ein Spektralfilter 26, sodass ein symmetrischer Aufbau an beiden Flachseiten des Kristallfehlstellenresonators 20d vorliegt.

### Bezugszeichenliste

- 2a-d: Frequenzanalysator
- 4a-d: Sensorkopf
- 6: HF-Empfangsantenne
- 8: Auswerteeinheit
- 10: Strahlungsdetektor
- 12: Lichtquelle
- 14: optischer Pumpstrahler
- 16: HF-Strahlung
- 18: Lichtleiter
- 20a-d: Kristallfehlstellenresonators
- 22: HF-Wellenleiter
- 24: Polarisationsfilter
- 26: Spektralfilter
- 28: aktiver Bereich
- 30: Magnetfeldeinheit
- 32: Schlitten
- 34: Antrieb
- 36: Impedanzeinheit
- 38: Anschluss
- 40: Lumineszenzstrahlung
- 42: Lumineszenzstrahlung
- 44: Lichtverteiler
- 46: Detektoreinheit
- F: Frequenz
- S: Signalstärke

## Patentansprüche

1. Sensorkopf (4a-d) für einen Frequenzanalysator (2a-d) enthaltend einen Kristallfehlstellenresonator (20a-d), einen optischen Pumpstrahler (14) zum Anregen des Kristallfehlstellenresonators (20a-d), eine Magnetfeldeinheit (30) zur Erzeugung eines Magnetfelds mit einem Magnetfeldgradienten entlang des Kristallfehlstellenresonators (20a-d), einen HF-Wellenleiter (22) und einen Strahlungsdetektor (10) zum Detektieren von Lumineszenzstrahlung (42) aus dem Kristallfehlstellenresonator (20a-d),
**dadurch gekennzeichnet,**
**dass** der Kristallfehlstellenresonator (20a-d) eine polykristalline Struktur aufweist.

2. Sensorkopf (4a-d) nach Anspruch 1,
**gekennzeichnet**
**durch** einen Polarisator (24) zwischen dem Kristallfehlstellenresonator (20a-d) und dem Strahlungsdetektor (10), dessen Polarisationsrichtung parallel zum Magnetfeld ausgerichtet ist.

3. Sensorkopf (4b-d) nach Anspruch 1 oder 2,
**dadurch gekennzeichnet,**
**dass** die polykristalline Struktur durch epitaktisches Wachstum der Kristalle auf einem Substrat erzeugt wurde.

4. Sensorkopf (4b-d) nach einem der vorhergehenden Ansprüche,
**dadurch gekennzeichnet,**
**dass** der Kristallfehlstellenresonator (20a-d) und ein aktiver Bereich (28) des Strahlungsdetektors (10) jeweils als Schicht ausgeführt sind und zumindest mittelbar über ihre Flachseiten miteinander verbunden sind.

5. Sensorkopf (4a-d) nach Anspruch 4,
**dadurch gekennzeichnet,**
**dass** zwischen dem Kristallfehlstellenresonator (20a-d) und dem aktiven Bereich (28) des Strahlungsdetektors (10) ein schichtförmiger Polarisator (24) und ein schichtförmiger Spektralfilter (26) angeordnet sind.

6. Sensorkopf (4a-b) nach einem der vorhergehenden Ansprüche,
**dadurch gekennzeichnet,**
**dass** der HF-Wellenleiter (22) als Schicht auf dem Kristallfehlstellenresonator (20ab) aufgebracht ist.

7. Sensorkopf (4b-d) nach einem der vorhergehenden Ansprüche,
**dadurch gekennzeichnet,**
**dass** zumindest ein Teil des HF-Wellenleiters (22) eine Schicht mit Nanodrähten enthält.

8. Sensorkopf (4c-d) nach einem der vorhergehenden Ansprüche,
**dadurch gekennzeichnet,**
**dass** zumindest ein Teil des HF-Wellenleiters (22) und der Kristallfehlstellenresonator (20c-d) in einer gemeinsamen Schicht miteinander vermischt vorliegen.

9. Sensorkopf (4c-d) nach einem der vorhergehenden Ansprüche,
**dadurch gekennzeichnet,**
**dass** zumindest ein Teil des HF-Wellenleiters (22) und der Kristallfehlstellenresonator (20c-d) in einer gemeinsamen Dispersionsschicht zumindest mittelbar auf ein Substrat aufgebracht wurden.

10. Sensorkopf (4b-c) nach einem der vorhergehenden Ansprüche,
**dadurch gekennzeichnet,**
**dass** der optische Pumpstrahler (14) als Schicht zumindest mittelbar auf dem Kristallfehlstellenresonator (20b-c) angeordnet ist.

11. Sensorkopf (4b) nach einem der vorhergehenden Ansprüche,
**dadurch gekennzeichnet,**
**dass** der HF-Wellenleiter (22) als Schicht zwischen dem optische Pumpstrahler (14) und dem Kristallfehlstellenresonator (20b) angeordnet ist.

12. Sensorkopf (4d) nach einem der Ansprüche 1 bis 10,
**dadurch gekennzeichnet,**
**dass** der Kristallfehlstellenresonator (20d) als Schicht ausgeführt ist und der Strahlungsdetektor (10) zwei schichtförmige Detektoreinheiten (46) enthält, wobei der Kristallfehlstellenresonator (20d) zwischen den beiden Detektoreinheiten (46) angeordnet ist.

13. Sensorkopf (4a-d) nach einem der vorhergehenden Ansprüche,
**gekennzeichnet**
**durch** eine Impedanzeinheit (36) mit einem elektrischen Leiter entlang des Kristallfehlstellenresonators (20a-d) mit einem elektrischen Anschluss (38) zum Halten des elektrischen Leiters auf einem vorbestimmten elektrischen Potenzial.

14. Sensorkopf (4a-d) nach einem der vorhergehenden Ansprüche,
**dadurch gekennzeichnet,**
**dass** die Magnetfeldeinheit (30) ein Halbach-Array enthält.

15. Verfahren zum Analysieren eines Frequenzspektrums von Strahlung, bei dem die Strahlung in eine HF-Empfangsantenne (6) eingekoppelt wird, die mit einem HF-Wellenleiter (22) eines Sensorkopfs (4a-d) eines Frequenzanalysators (2a-d) verbunden ist, die Strahlung mit einem durch optisches Pumpen angeregten und in einem Gradientenmagnetfeld liegenden Kristallfehlstellenresonator (20a-d) interagiert und Lumineszenzstrahlung (42) aus dem Kristallfehlstellenresonator (20a-d) einen Strahlungsdetektor (10) erreicht,
**dadurch gekennzeichnet,**
**dass** der Kristallfehlstellenresonator (20a-d) eine polykristalline Struktur aufweist und die Lumineszenzstrahlung (42) mit einem Polarisationsfilter (24) gefiltert wird.
